# EUROPEAN PATENT APPLICATION

(11) **EP 2 234 186 A1**
(43) Date of publication of application: **29.09.2010**
(21) Application number: 08869573.9
(22) Date of filing: 17.12.2008
(51) Int. Cl.: H01L 51/50, H05B 33/10, H05B 33/12, H05B 33/22

(54) **ORGANIC ELECTROLUMINESCENCE ELEMENT AND METHOD FOR MANUFACTURING THE SAME**

(30) Priority: 08.01.2008 JP 2008001630
(71) Applicant: Sumitomo Chemical Company, Limited, Tokyo 104-8260 (JP)
(72) Inventor: ROKUHARA, Kouichi, Shimotsuma-shi Ibaraki 304-0823 (JP); AMAMIYA, Satoshi, Ehime 792-0025 (JP)
(74) Representative: Jackson, Martin Peter
(86) International application number: PCT/JP2008/072983
(87) International publication number: WO 2009/087876

(57) **Abstract**

An organic electroluminescence element includes: a substrate (111); a first electrode layer (121) provided above the surface of the substrate; an organic base layer (141) that is provided covering at least a part of the first electrode layer, and is made of a material insoluble in water; a bank (131B) that is provided covering a part of the organic base layer, and is arranged with a plurality of pixel areas (132B) provided above the organic base layer; an organic light-emitting layer (142) provided within the pixel areas; and a second electrode layer (122) provided above the organic light-emitting layer.

## Description

### TECHNICAL FIELD

The present invention relates to an organic electroluminescence element (hereinafter, also referred to as an "organic EL element"), and relates to a method for manufacturing the same.

### BACKGROUND ART

In a conventional manufacturing of display devices having a number of organic EL elements as pixels, disclosed is an organic electroluminescence element in which a solution that contains poly(3,4)ethylenedioxythiophene/polystyrene sulfonate is applied on a substrate by spin coating to provide an organic base layer as a hole injection layer, and then a bank is provided on the organic base layer (Patent Document 1).

Patent Document 1: JP 2004-235128 A

### DISCLOSURE OF INVENTION

### PROBLEM TO BE SOLVED BY THE INVENTION

However, when the bank is formed by a photolithography method, that is, through steps of providing a photoresist layer, then exposing the layer to light and developing it to remove a part of the layer, the thickness of the hole injection layer of the organic EL element becomes nonuniform. This leads to disadvantages of impairing light-emitting properties, and further display quality.

An object of the present invention is to provide an organic EL element that can have favorable light-emitting properties, and thus can perform favorable display quality, and to provide a manufacturing method by which the organic EL element can be easily formed.

### MEANS FOR SOLVING PROBLEM

The present inventors devoted themselves to studying to solve the disadvantages described above. As a result of this, the inventors have found that: when a specific organic base layer is used, the organic base layer is not impaired even when a bank (grid-like partition with which pixel areas are sectioned) is provided above the organic base layer; and consequently, an organic EL element that can have favorable light-emitting properties with low fluctuation in light emission intensity, and then have favorable display quality can be easily formed; thus completing the present invention.

Specifically, the present invention provides the following.
[1] An organic electroluminescence element comprising:
   a substrate;
   a first electrode layer that is provided above at least a partial area of a surface of the substrate;
   an organic base layer that is provided above at least a partial area of a surface of the first electrode layer and is made of an organic material insoluble in water;
   a bank that is provided above the organic base layer and is arranged with a plurality of pixel areas provided above the organic base layer;
   an organic light-emitting layer provided above the organic base layer and within the pixel areas; and
   a second electrode layer provided above the organic
   light-emitting layer.
[2] The organic electroluminescence element according to [1], wherein the organic base layer is a hole injection layer.
[3] The organic electroluminescence element according to [1], wherein the organic base layer includes a first organic base layer and a second organic base layer stacked above the first organic base layer, the first organic base layer is a hole injection layer, and the second organic base layer is an interlayer.
[4] The organic electroluminescence element according to any one of [1] to [3], wherein the resistivity of the organic base layer is equal to or more than 1×10¹⁰ Ωcm.
[5] The organic electroluminescence element according to any one of [1] to [4], wherein the organic material insoluble in water is a crosslinked polymer compound.
[6] A method for manufacturing the organic electroluminescence element according to any one of [1] to [5], the manufacturing method comprising:
   preparing a substrate;
   providing a first electrode layer above at least a partial area of a surface of the substrate;
   providing an organic base layer above at least a partial area of the first electrode layer;
   providing a bank above the organic base layer;
   providing an organic light-emitting layer within a pixel area defined by the bank; and
   providing a second electrode layer above the organic light-emitting layer.

### EFFECT OF THE INVENTION

The organic EL element of the present invention has the organic base layer below the bank as a part of the stacked structure of a light-emitting element. In addition, an organic material insoluble in water is used for the organic base layer. Therefore, more favorable light-emitting properties, and then more favorable display quality of the organic EL element can be obtained. Moreover, by the manufacturing method of the organic EL element of the present invention, the organic EL element of the present invention having the structure described above can be easily manufactured.

### BRIEF DESCRIPTION OF DRAWINGS

[Fig. 1] Fig. 1 is a sectional schematic illustrating a manufacturing process in an example of a manufacturing method of an organic EL element of the present invention.
[Fig. 2] Fig. 2 is a sectional schematic illustrating a manufacturing process subsequent to the manufacturing process illustrated in Fig. 1.
[Fig. 3] Fig. 3 is a sectional schematic of a structure of a part of an example of the organic EL element of the present invention.
[Fig. 4] Fig. 4 is a sectional schematic of a structure of a part of another example of the organic EL element of the present invention.
[Fig. 5] Fig. 5 is a perspective schematic illustrating a positional relationship between a substrate and electrodes in an example of the organic EL element of the present invention.
[Fig. 6] Fig. 6 is a sectional schematic of a structure of a part of another example of the organic EL element of the present invention.

### EXPLANATIONS OF LETTERS OR NUMERALS

- 111: substrate
- 121: first electrode layer
- 122: second electrode layer
- 131A: photoresist layer
- 131B: bank
- 132R: pixel area
- 141, 641A, 641B: organic base layer
- 142: light-emitting layer

### BEST MODE(S) FOR CARRYING OUT THE INVENTION

Embodiments of the present invention are described below in detail with reference to the accompanying drawings. Each of the drawings only schematically illustrates shape, size, and placement of components to an extent necessary for understanding the present invention. The present invention is not limited to the descriptions below, and various changes and modifications may be made on each of the components without departing from the spirit and scope of the present invention. In each of the drawings used for the descriptions below, the same numerals are given to the same or similar components, and overlapping descriptions may be omitted.

The organic EL element of the present invention includes: a substrate; a first electrode layer that is provided above at least a partial area of the surface of the substrate; an organic base layer provided above at least a partial area of the surface of the first electrode layer; a bank that is provided above the organic base layer and is arranged with a plurality of pixel areas provided above the organic base layer; an organic light-emitting layer provided above the organic base layer and within the pixel areas; and a second electrode layer provided above the organic light-emitting layer.

### 1. Substrate

For the substrate used in the present invention, various substrates used in organic EL elements may be employed. In the description regarding structure of layers of the organic EL element, "above(upper)," "below(lower)," and "horizontal" as to direction indicate positional relationships when the substrate is placed in a horizontal position, and the light-emitting layer and the other layers are provided at the upper side of the substrate, unless otherwise noted.

### 2. Electrode layer

The organic EL element of the present invention includes, as electrodes, the first electrode layer provided above the substrate, and the second electrode layer provided above the organic base layer and the light-emitting layer. One of the electrodes serves as an anode, and the other serves as a cathode. Generally, the first electrode layer serves as an anode, but not limited to this, and the second electrode layer may serve as an anode instead.

The specific shape of the electrode layer is not particularly limited, and the electrode layer may take various shapes suitable for a segment display element, a dot-matrix display element, and the like. Preferably, the electrode layer may take a shape that constitutes the dot matrix display element such as an active matrix display element or a passive matrix display element. The first electrode layer may be provided above the whole surface of the substrate, but usually, is provided above a partial area of the surface of the substrate in a pattern for constituting a number of pixels.

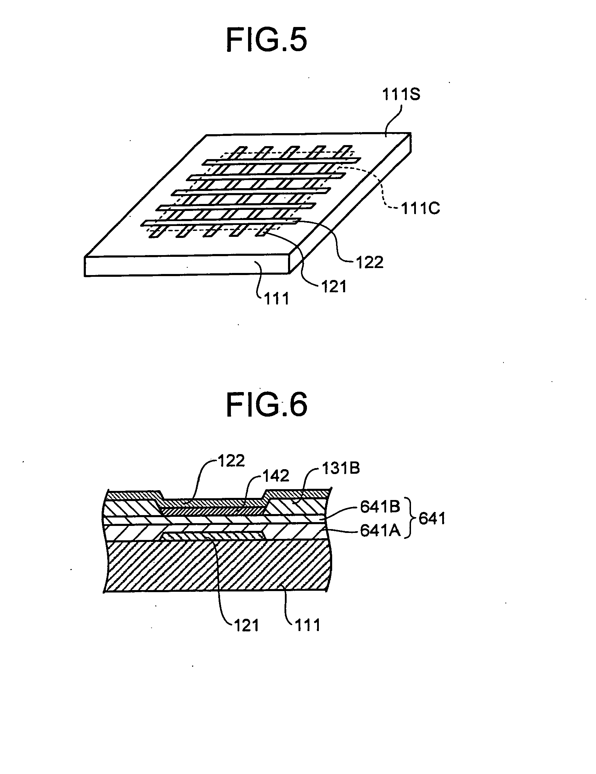

A rough schematic of an example of the shape of electrode layers that constitute a passive matrix is illustrated in Fig. 5. Fig. 5 is a perspective schematic illustrating a positional relationship between a substrate and a passive matrix electrode in an example of the organic EL element of the present invention. In the example, first electrode layers 121 are provided on the surface of a substrate 111 as lines parallel to each other. Second electrode layers 122 are provided in a state of crossing the first electrode layers 121. A circuit (not illustrated) for driving a display device that is connected to each electrode, and through which voltage is applied may be provided. At each of the points of intersection of the first electrode layers 121 and the second electrode layers 122, a pixel area (not illustrated in Fig. 5) defined with a bank described latter may be provided.

### 3. Organic base layer

In the organic EL element of the present invention, the organic base layer is provided above at least a partial area of the surface of the first electrode layer.
The organic base layer is provided "above at least a partial area" of the first electrode layer, which means a state where at least a partial area of the upper surface of the first electrode layer has an area above which the organic base layer is provided. Therefore, the organic base layer may cover the whole upper surface of the first electrode layer, or the organic base layer may cover only a part of the upper surface of the first electrode layer. However, typically, the part of the first electrode layer that belongs to the pixel areas described latter is configured so that the organic base layer covers the whole surface of the part. The part of the surface of the substrate that is not covered with the first electrode layer may be or may not be covered with the organic base layer.

The organic base layer may be in a state where one organic base layer constituting one area occupies a part or the whole of the area on the surface of a single substrate. Alternatively, the organic base layer may be in a state where the surface of a single substrate is divided into a plurality of areas, and a plurality of partial areas of the organic base layer, such as island-shaped areas, occupy each of the divided areas on the substrate; that is, the organic base layer is provided in the form comprising the partial areas that are separated from each other.

In a preferable embodiment of the present invention, the organic base layer is provided to cover the whole surface of an area that includes a plurality of pixel areas on the substrate, and more preferably to cover the whole surface of an area that includes the whole of the pixel areas on the substrate. By providing the organic base layer in such embodiments, a uniform organic base layer may be formed by a simple method such as a spin coating method.

The structure of such organic base layer is described again with reference to Fig. 5. An organic base layer (not illustrated) is preferably provided as a single layer covering both of the first electrode layers 121 on the surface of the substrate 111 and the part of the surface of the substrate 111 on which the first electrode layers are not formed, in the area 111C that includes the whole of the pixel areas illustrated as the points of intersection of the electrodes 121 and 122.

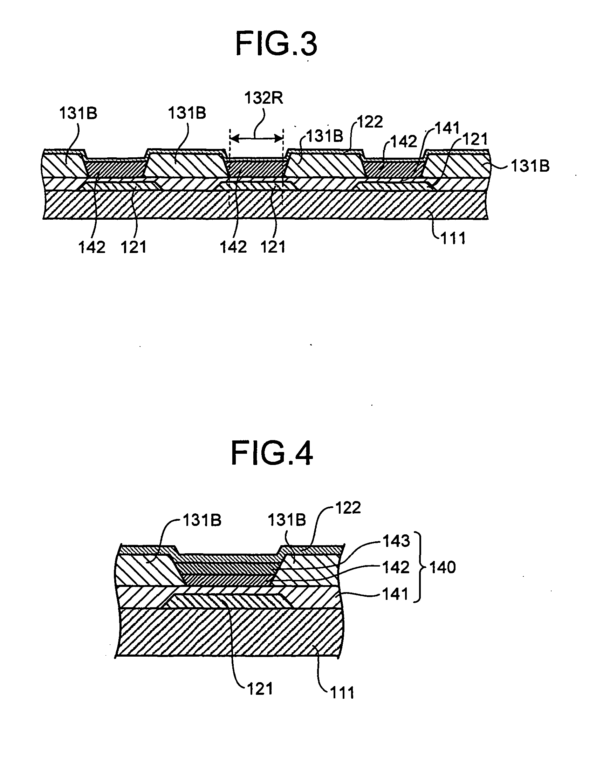

Moreover, a structure of such an organic base layer is described with reference to Fig. 3. Fig. 3 is a sectional schematic of a structure of a part of an example of the organic EL element of the present invention that includes a passive matrix electrode in the same manner as that of Fig. 5. In this example, a plurality of the first electrode layers 121 are provided on the substrate 111, and an organic base layer 141 is seamlessly formed as a single layer covering both of the first electrode layers 121 and the gaps between the first electrode layers 121 on the surface of the substrate 111 that are not covered with the first electrode layers 121. With such a structure, an organic base layer that has uniform thickness on the first electrode layer, and has small fluctuation in thickness between the pixel areas, can be easily provided above the first electrode layer by a simple method such as a spin coating method.

As illustrated in Fig. 3, the organic EL element of the present invention may include only a single organic base layer having no stacked structure.
On the other hand, as illustrated in Fig. 6, the organic EL element of the present invention may have equal to or more than two organic base layers having a stacked structure, and further may also have equal to or more than three organic base layers. Fig. 6 is a sectional schematic of a structure of a part of another example of the organic EL element of the present invention.
In the example illustrated in Fig. 6, the organic EL element has two layers of a first organic base layer 641A that covers both of the substrate 111 and the first electrode layers 121, and of a second organic base layer 641B stacked on the first organic base layer 641A. When the organic base layer is provided as a layer that includes equal to or more than three layers, the gap between the electrode and the bank becomes large. This may lead to crosstalk with adjacent pixel areas, and thus the organic base layer may be preferably one layer or two layers.
As described above, there is an embodiment that the surface of the substrate is divided into a plurality of areas and each of the divided areas is occupied with a different organic base layer (a partial area), thus providing the organic base layer comprising a plurality of the partial areas. In this case, each of the divided partial areas may have a single layer of the organic base layer or two or more of the organic base layers which are stacked.

The organic base layer of the organic EL element of the present invention is a layer necessary for constituting an organic EL element, and may have a function of any layers other than the first electrode layer. Generally, in the organic EL element, the organic base layer may be a part of or the whole of the layers formed between the electrode and the light-emitting layer.
For example, when the first electrode layer is the anode, the organic base layer may be one or more layers of a hole injection layer, an interlayer and a hole transport layer. In a more preferable embodiment, the organic EL element of the present invention may have only a single layer of the hole injection layer as the organic base layer; or the organic EL element of the present invention may have a first organic base layer and a second organic base layer stacked thereon, and the first organic base layer may be the hole injection layer, and the second organic base layer may be the interlayer.
In contrast, when the first electrode is the cathode, the organic base layer may be one or more layers of an electron injection layer, an interlayer and an electron transport layer. In a more preferable embodiment, the organic EL element of the present invention may have only a single layer of the electron injection layer as the organic base layer; or the organic EL element of the present invention has a first organic base layer and a second organic base layer stacked thereon, and the first organic base layer may be the electron injection layer, and the second organic base layer may be the interlayer.

In the present invention, the resistivity of the organic base layer is preferably equal to or more than 1×10¹⁰ Ωcm. The resistivity of the organic base layer can be measured by a resistivity meter (for example, Loresta GP MCP-T610 manufactured by Dia Instruments Co., Ltd.).

In the present invention, the organic base layer is made of an organic material insoluble in water. When the organic base layer comprises a plurality of layers, at least a top layer adjacent to the bank is, preferably all of the layers are, made of the organic material insoluble in water. The organic base layer used in the present invention is made of the organic material insoluble in water; therefore, even when a solution that contains water is applied on the organic base layer, the film thickness of the layer does not substantially decrease. The amount of the organic material insoluble in water to be dissolved in 1 gram of water, is preferably, equal to or less than 0.1 milligram, more preferably, equal to or less than 0.01 milligram, and further preferably, equal to or less than 0.001 milligram.

The present invention has such advantages that the organic EL element can be formed by a simple film forming method such as a spin coating method, by providing one or more layers that constitutes the element below the bank as the organic base layer. Moreover, by employing the material insoluble in water for the organic base layer, the organic base layer is not impaired at a subsequent step of forming of the bank. As a result, favorable light-emitting properties, and thus display performance with high quality can be obtained.

### 4. Bank

In the present invention, the bank is provided above the organic base layer. When the organic base layer is sectioned into a plurality of the partial areas, a plurality of pixel areas is defined on each of the organic base layers. The pixel areas are defined "on each of" the organic base layers, which means that when the organic base layer provided above the substrate comprising the partial areas separated from each other, a plurality of the pixel areas are defined on each of the partial areas. When the organic base layer is composed as only one area on the substrate, as a matter of course, all of the pixel areas are defined on the organic base layer. With such a structure, in the organic EL element of the present invention, the organic base layer for a plurality of pixels adjacent to each other are formed in one. That is, in one area that includes a plurality of the pixels adjacent to each other on the surface of the substrate, and preferably, in one area that includes all of the pixels on the surface of the substrate, the organic base layer constitutes a single seamless layer, but not separated partial areas.

The structure is described again with reference to the example of Fig. 3. A bank 131B is provided on the organic base layer 141 and surrounds a rectangular area 132R in which the electrodes 121 and 121 are provided at the top and the bottom to define a pixel area within the area 132R. In other words, the area 132R surrounded with the bank, on which no bank is provided, serves as the pixel area; thus, a plurality of pixel areas 132R are defined on one of a plurality of partial areas of the organic base layer 141 separated from each other.

### 5. Organic light-emitting layer

In the present invention, the organic light-emitting layer is provided within the pixel area defined by the bank. The second electrode layer described above may further be formed above the organic light-emitting layer, thus provided to constitute the organic EL element. This structure is described with reference to the example of Fig. 3. An organic light-emitting layer 142 is provided by being filled in the pixel area 132R defined by the bank 131B, and is stacked on the first electrode layer 121 with the organic base layer 141 interposed therebetween. Second electrode layer 122 is provided on the organic light-emitting layers 142 to intersect the first electrode layer 121 at a right angle. In such a manner, an organic EL element in which the organic base layer and the light-emitting layer are stacked between the first electrode layer and the second electrode layer may be composed.

### 6. Sealing member

As illustrated in Fig. 5, the organic EL element of the present invention may further include a member for sealing at a side opposite to the substrate with each of the layers interposed therebetween. Fig. 5 is a perspective schematic illustrating a positional relationship between a substrate and electrodes in an example of the organic EL element of the present invention.
The sealing member can seal each layer that constitutes the element by, for example, being bonded with the substrate 111 with a bonding layer that is interposed therebetween, and that is provided at a peripheral area 111S of the area 111C including the pixel areas.

### 7. Other components

As illustrated in Fig. 4, the organic EL element of the present invention may further include other components in addition to the components described above. Fig. 4 is a sectional schematic of a structure of a part of another example of the organic EL element of the present invention.
Specifically, for example, in addition to the organic light-emitting layer, one or more other layers may further be provided within the pixel area defined by the bank. In the organic EL element of the present invention, for example, a stacked structure 140 provided between the first electrode layer 121 and the second electrode layer 122 includes three layers that include besides the organic base layer 141 and the organic light-emitting layer 142, further another layer 143.

The structure of the layers of the organic EL element of the present invention that has the essential components described above and optional components is described more specifically below.

Generally, an organic EL element has at least a pair of electrodes (an anode and a cathode), and has at least an organic light-emitting layer between the electrodes. A hole injection layer may be optionally provided between the anode and the organic light-emitting layer. Moreover, one or more layers of an interlayer and a hole transport layer may be optionally provided between the organic light-emitting layer and the hole injection layer (when the hole injection layer exists) or between the organic light-emitting layer and the anode (when the hole injection layer does not exist). In contrast, an electron injection layer may be optionally provided between the cathode and the organic light-emitting layer. Moreover, one or more layers of an interlayer and an electron transport layer may be optionally provided between the organic light-emitting layer and the electron injection layer (when the electron injection layer exists) or between the organic light-emitting layer and the cathode (when the electron injection layer does not exist). In other words, the organic EL element may have a layered structure a) described below, or may also have a layered structure in which one or more layers of the hole injection layer, the hole transport layer, the interlayer, the electron transport layer, or the electron injection layer may be omitted from the layered structure a).

a) anode-hole injection layer-(any one of hole transport layer and interlayer or both)-light-emitting layer-(any one of electron transport layer and interlayer or both)-electron injection layer-cathode

The mark "-" indicates that each layer is adjacently stacked. "(Any one of hole transport layer and interlayer or both)" indicates a layer that is composed of only the hole transport layer, a layer that is composed of only the interlayer, a layered structure of hole transport layer-interlayer, a layered structure of interlayer-hole transport layer, or other optional layered structures that include one or more layers of each of the hole transport layer and the interlayer. "(Any one of electron transport layer and interlayer or both)" indicates a layer that is composed of only the electron transport layer, a layer that is composed of only the interlayer, a layered structure of electron transport layer-interlayer, a layered structure of interlayer-electron transport layer, or other optional layered structures that include one or more layers of each of the electron transport layer and the interlayer. The same meaning shall apply to the description of the layered structures below.

The organic EL element may further include two-layered light-emitting layers in a stacked structure. In this case, the organic EL element may have a layered structure b) described below, or may also have a layered structure in which one or more layers of the hole injection layer, the hole transport layer, the interlayer, the electron transport layer, or the electron injection layer may be omitted from the layered structure b).

b) anode-hole injection layer-(any one of hole transport layer and interlayer or both)-light-emitting layer-(any one of electron transport layer and interlayer or both)-electron injection layer-electrode-hole injection layer-(any one of hole transport layer and interlayer or both)-light-emitting layer-(any one of electron transport layer and interlayer or both)-electron injection layer-cathode

Moreover, the organic EL element may include three or more layers of light-emitting layers in a single stacked structure. In this case, the organic EL element may have a layered structure c) described below, or may also have a layered structure in which one or more layers of the hole injection layer, the hole transport layer, the interlayer, the electron transport layer or the electron injection layer may be omitted from the layered structure c).

c) anode-hole injection layer-(any one of hole transport layer and interlayer or both)-light-emitting layer-(any one of electron transport layer and interlayer or both)-electron injection layer-repeating unit A-repeating unit A, and so on-cathode
"Repeating unit A" indicates a unit of the layered structure of electrode-hole injection layer-(any one of hole transport layer and interlayer or both)-light-emitting layer-(any one of electron transport layer and interlayer or both)-electron injection layer.

The organic EL element of the present invention may also have a layered structure similar to the layered structure described above that may be taken in a general organic EL element. When the first electrode layer is the anode, one or more layers, preferably, one or two layers, at a side near the anode may be the organic base layer, and a layer located farther than the organic base layer may be provided within the pixel area defined by the bank. On the other hand, when the first electrode layer is the cathode, one or more layers, preferably, one or two layers, at a side near the cathode may be the organic base layer.

Preferable specific examples of the layered structure of the organic EL element of the present invention include the following. In the description below, a component put in symbols < > indicates a layer provided as the organic base layer. The other components except for the electrode indicate layers provided within the pixel area defined by the bank.

d) anode-<hole injection layer>-organic light-emitting layer-cathode
e) anode-<hole transport layer>-organic light-emitting layer-cathode
f) anode-<interlayer>-organic light-emitting layer-cathode
g) anode-<hole injection layer-hole transport layer>-organic light-emitting layer-cathode
h) anode-<hole injection layer-interlayer>-organic light-emitting layer-cathode
i) anode-<hole injection layer>-hole transport layer-interlayer-organic light-emitting layer-cathode
j) anode-<hole transport layer>-interlayer-organic light-emitting layer-cathode
k) anode-<hole injection layer-hole transport layer>-interlayer-organic light-emitting layer-cathode
d²) to k²) in the d) to k), a layered structure that further includes an electron injection layer at a position between the organic light-emitting layer and the cathode.
d³) to k³) in the d) to k), a layered structure that further includes interlayer-electron transport layer at a position between the organic light-emitting layer and the cathode.
d⁴) to k⁴) in the d²) to k²), a layered structure that further includes interlayer-electron transport layer at a position between the organic light-emitting layer and the electron injection layer.
As indicated in the examples described above, when the interlayer is provided, the interlayer is preferably adjacent to the light-emitting layer.

The organic EL element of the present invention may also include an insulating layer having a film thickness of equal to or less than 2 nanometers, to be adjacent to the electrode to further improve adhesion with the electrode and improve the injection of charges (that is, holes or electrons) from the electrode. A thin buffer layer may also be inserted into an interface of a charge transport layer (that is, a hole transport layer or an electron transport layer) or of the organic light-emitting layer to improve adhesion at the interface, to prevent mixing, and the like.
The order or the number of the layers to be stacked and the thickness of each of the layers may be appropriately set in consideration of light-emitting efficiency or element life.

When the organic EL element of the present invention is composed as an element for a bottom emission type display device that emits light from the side of the substrate, all layers closer to the side of the substrate than at least the organic light-emitting layer may be transparent or semitransparent. On the other hand, when the organic EL element of the present invention is constituted as an element for a top emission type display device that emits light from the side opposite to the substrate, all layers closer to the side of the second electrode layer than at least the organic light-emitting layer may be transparent or semitransparent.

For example, when the organic EL element illustrated in Fig. 3 is an element for the bottom emission type display device, all layers closer to the side of the substrate than the organic light-emitting layer 142, that is, all of the organic base layer 141, the first electrode layer 121, and the substrate 111 may constitute the element to be transparent or semitransparent. On the other hand, when the organic EL element illustrated in Fig. 3 is an element for the top emission type display device, all layers closer to the side of the second electrode layer than the organic light-emitting layer 142, that is, all of the second electrode layers 122 and the sealing member (not illustrated) may constitute the element to be transparent or semitransparent. Transparent or semitransparent indicates that the transmittance of visible light from the light-emitting layer to the layer from which light is emitted is preferably equal to or more than 40 percent. For the element to which light-emitting in an ultraviolet region or an infrared region is required, the transmittance at the area is preferably equal to or more than 40 percent.

The organic EL element of the present invention may include optional components that constitute a display device, for example, filters such as color filters or fluorescence conversion filters, and wiring necessary for driving the pixels, as needed.

### 8. Material that constitutes each layer

The material of and the forming method of each layer that constitutes the organic EL element of the present invention are described more specifically below.

### <Substrate>

Any substrate is applicable to the substrate included in the organic EL element of the present invention as long as it remains unchanged while an electrode is formed and the layer of an organic substance is formed. Examples of the substrate used may include glass, plastic, a polymer film, a silicon substrate, and a stacked matter thereof. The substrate is commercially available, or may be manufactured by a publicly known method.

### <Anode>

For the anode of the organic EL element of the present invention, a transparent or a semitransparent electrode is preferably used, because with such an electrode, an element that emits light through the anode can be composed. For such a transparent or a semitransparent electrode, a thin film of metallic oxides, metallic sulphides, and metal, all of which have high electric conductivity, may be used. An electrode with high transparency may be preferably utilized and is used by being appropriately selected depending on an organic layer used. Specific examples of the anode include: indium oxide, zinc oxide, tin oxide; a film (such as NESA)-a complex thereof-produced by using electrically conductive glass made of indium tin oxide (ITO), indium zinc oxide or the like; gold, platinum, silver, and copper, and the like. Among them, ITO, indium zinc oxide, and tin oxide are preferred. Examples of the manufacturing method may include a vacuum deposition method, a sputtering method, an ion plating method, and a plating method. As the anode, an organic transparent conductive film such as polyaniline or a derivative thereof and polythiophene or a derivative thereof may be used.
For the anode, a material that reflects light may be used. For such material, metals, metallic oxides, and metallic sulphides, all of which have a work function of equal to or more than 3.0 electron volts, are preferred.

The film thickness of the anode may be appropriately selected in consideration of light transparency and electric conductivity, and is for example, 10 nanometers to 10 micrometers, preferably 20 nanometers to 1 micrometer, and more preferably 50 nanometers to 500 nanometers.

### <Hole injection layer>

The hole injection layer may be provided between the anode and the hole transport layer or between the anode and the light-emitting layer.
In the organic EL element of the present invention, examples of a material that forms the hole injection layer include: phenylamine series; starburst-type amine series; phthalocyanine series; an oxide such as vanadium oxide, tantalum oxide, tungsten oxide, molybdenum oxide, ruthenium oxide, and aluminum oxide; amorphous carbon; polyaniline or a derivative thereof; polyfluorene or a derivative thereof; polyarylamine or a derivative thereof; and a polythiophene or a derivative thereof.

The optimal value for the film thickness of the hole injection layer varies depending on the material used. Although the film thickness may be selected to have appropriate values of driving voltage and light-emitting efficiency, at least a thickness with which no pinhole is formed is required. When the thickness is too large, the driving voltage of the element may increase. Accordingly, the film thickness of the hole injection layer is, for example, 1 nanometer to 1 micrometer, preferably, 2 nanometers to 500 nanometers, and more preferably, 5 nanometers to 200 nanometers.

Although a film forming method of the hole injection layer is not limited, for a low molecular hole injection material, a method of forming a film from a mixed solution of the low molecular hole injection material and a polymer binder is shown as an example. For a polymer hole injection material, a method of forming a film from a solution is shown as an example.

A solvent used for forming a film from the solution is not particularly limited as long as the solution dissolves the hole injection material. Examples of the solvent include: a chlorine based solvent such as chloroform, methylene chloride and dichloroethane; an ether based solvent such as tetrahydrofuran; an aromatic hydrocarbon based solvent such as toluene and xylene; a ketone based solvent such as acetone and methyl ethyl ketone; and an ester based solvent such as ethyl acetate, butyl acetate and ethyl cellosolve acetate.

Examples of the available method of forming a film from the solution include applying methods of the solution such as: a coating method, for example, a spin coating method, a casting method, a micro-gravure coating method, a gravure coating method, a bar coating method, a roll coating method, a wire bar coating method, a dip coating method, a slit coating method, a capillary coating method, a spray coating method and a nozzle coating method; and a printing method, for example, a gravure printing method, a screen printing method, a flexo printing method, an offset printing method, a reverse printing method and an ink-jet printing method. The printing method such as a gravure printing method, a screen printing method, a flexo printing method, an offset printing method, a reverse printing method and an ink-jet printing method is preferable in that a pattern formation is easy.

For the polymer binder to be mixed, a binder that does not extremely inhibit charge transportation is preferable, and a binder that does not have strong absorption of visible light is suitably used. Examples of the polymer binder may include polycarbonate, polyacrylate, polymethyl acrylate, polymethyl methacrylate, polystyrene, polyvinyl chloride, and polysiloxane.

In the present invention, when the hole injection layer is provided as an organic base material insoluble in water, a polymer compound that is selected from the group consisting of polyaniline or a derivative thereof, polyfluorene or a derivative thereof, polyarylamine or a derivative thereof, and a polythiophene or a derivative thereof, and that has no hydrophilic group is preferably used as a material for the hole injection layer. Examples of the particularly preferable material for the hole injection layer may include a polymer compound that has a repeating unit of the following Formula (1), a polymer compound that has a repeating unit of the following Formula (2) and a polymer compound that has the repeating unit of Formula (1) and the repeating unit of Formula (2).

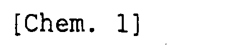

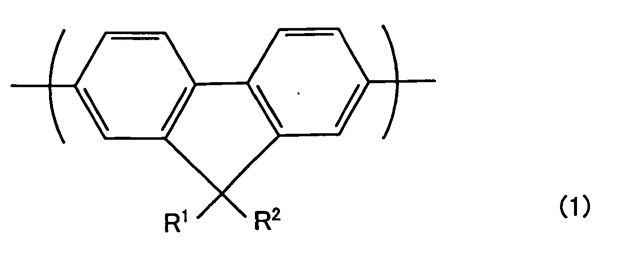

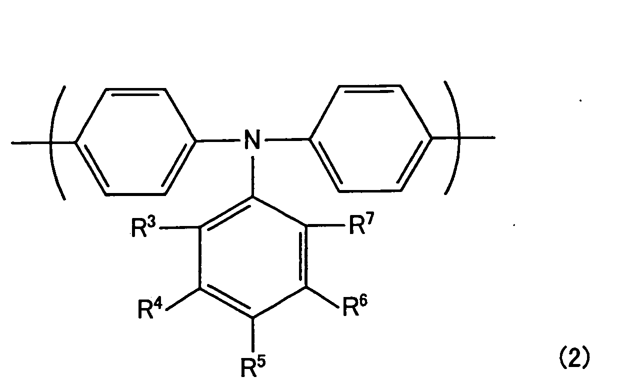

(in Formulae (1) and (2), R¹, R², R³, R⁴, R⁵, R⁶, and R⁷ are each independently a hydrogen atom, an alkyl group, or an aryl group. R¹ and R² may be bonded to each other to form a ring. Any two substituents selected from R³ to R⁷ may be bonded to each other to form a ring.)

The alkyl group generally has a carbon number of 1 to 20, may be linear or branched, or may be a cycloalkyl group. Specific examples of the alkyl group may include methyl group, ethyl group, n-propyl group, i-propyl group, n-butyl group, i-butyl group, t-butyl group, s-butyl group, 3-methylbutyl group, n-pentyl group, n-hexyl group, 2-ethylhexyl group, n-heptyl group, n-octyl group, n-nonyl group, n-decyl group, and n-lauryl group.

The aryl group generally has a carbon number of 6 to 60, and may have a substituent. Examples of the substituent possessed by the aryl group may include a linear or branched alkyl group having a carbon number of 1 to 20, or a cycloalkyl group having a carbon number of 1 to 20. Specific examples of the aryl group may include a phenyl group, a C₁-C₁₂ alkyl phenyl group (C₁-C₁₂ indicates a carbon number of 1 to 12, the same applying to the following), 1-naphthyl group, 2-naphthyl group, preferably, an aryl group having a carbon number of 6 to 20, and more preferably, a C₁-C₁₂ alkyl phenyl group.

R¹ and R² may be bonded to each other to form a ring. Any two substituents selected from R³ to R⁷ may be bonded to each other to form a ring. Examples of the ring include a cyclobutane ring, a cyclopentane ring, a cyclohexane ring, a cycloheptane ring, a cyclooctane ring, a cyclononane ring, a cyclodecane ring, a cyclohexene ring, a cyclohexadiene ring, and a cyclooctatriene ring.

### <Hole transport layer>

Examples of a material that constitutes the hole transport layer may include polyvinyl carbazole or a derivative thereof, polysilane or a derivative thereof, a polysiloxane derivative having an aromatic amine at the side chain or the main chain, a pyrazoline derivative, an arylamine derivative, a stilbene derivative, a triphenyl diamine derivative, polyaniline or a derivative thereof, polythiophene or a derivative thereof, polyarylamine or a derivative thereof, polyfluorene or a derivative thereof, polypyrrole or a derivative thereof, poly(p-phenylene vinylene) or a derivative thereof, or poly(2, 5-thienylene vinylene) or a derivative thereof.

Although a film forming method of the hole transport layer is not limited, for a low molecular hole transport material, a method of forming a film from a mixed solution of the low molecular hole transport material and a polymer binder is shown as an example. For a polymer hole transport material, a method of forming a film from a solution is shown as an example. Examples of a solvent used for forming a film from the solution include a solvent similar to the solvent used for forming a film of the hole injection layer described above. Examples of the method of forming a film from the solution include a film forming method similar to the method of forming a film of the hole injection layer from the solution described above.

The optimal value for the film thickness of the hole transport layer varies depending on the material used. Although the film thickness may be selected to have appropriate values of driving voltage and light-emitting efficiency, at least a thickness with which no pinhole is formed is required. When the thickness is too large, the driving voltage of the element may increase. Accordingly, the film thickness of the hole transport layer is, for example, 1 nanometer to 1 micrometer, preferably, 2 nanometers to 500 nanometers, and more preferably, 5 nanometers to 200 nanometers.

In the present invention, when the hole transport layer is provided as an organic base material insoluble in water, a polymer compound that is selected from the group consisting of polyvinyl carbazole or a derivative thereof, polysilane or a derivative thereof, a polysiloxane derivative having an aromatic amine at the side chain or the main chain, polyaniline or a derivative thereof, polyfluorene or a derivative thereof, polyarylamine or a derivative thereof, a polythiophene or a derivative thereof, polypyrrole or a derivative thereof, poly(p-phenylene vinylene) or a derivative thereof, or poly(2, 5-thienylene vinylene) or a derivative thereof, and that has no hydrophilic group is preferably used as a material for the hole transport layer. Examples of the particularly preferable material for the hole transport layer may include a polymer compound that has a repeating unit of Formula (1), a polymer compound that has a repeating unit of Formula (2) and a polymer compound that has the repeating unit of Formula (1) and the repeating unit of Formula (2).

### <Interlayer>

Examples of a material that constitutes the interlayer include polyarylamine or a derivative thereof, or polyfluorene or a derivative thereof.

Although a film forming method of the interlayer is not limited, a method of forming a film from a solution is exemplified. Examples of a solvent used for forming a film from the solution may include a solvent similar to the solvent used for forming a film of the hole injection layer described above. Examples of the method of forming a film from the solution may include a film forming method similar to the method of forming a film of the hole injection layer from the solution described above.

The optimal value for the film thickness of the interlayer varies depending on the material used. Although the film thickness may be selected to have appropriate values of driving voltage and light-emitting efficiency, at least a thickness with which no pinhole is formed is required. When the thickness is too large, the driving voltage of the element may increase. Accordingly, the film thickness of the interlayer is, for example, 1 nanometer to 1 micrometer, preferably, 2 nanometers to 500 nanometers, and more preferably, 5 nanometers to 20 nanometers.

In the present invention, when the interlayer is provided as an organic base material insoluble in water, a polymer compound that is selected from the group consisting of polyfluorene or a derivative thereof; or polyarylamine or a derivative thereof, and that has no hydrophilic group is preferably used as a material for the interlayer. Examples of the particularly preferable material for the hole transport layer may include a polymer compound that has a repeating unit of Formula (1), a polymer compound that has a repeating unit of Formula (2), and a polymer compound that has the repeating unit of Formula (1) and the repeating unit of Formula (2).

The organic base layer used in the present invention is preferably made of a crosslinked polymer compound insoluble in water. The crosslinked polymer compound may be produced by curing a polymer compound having a cross-linking group, or may be produced by curing a mixture of a polymer compound and a cross-linking agent.

### <Bank>

The bank may be formed with using, for example, a photosensitive polyimide as the material. The bank is formed to substantially surround a lower electrode. The thickness of the bank may be about 0.1 micrometer to 5 micrometers. For the material for the bank, an organic material that has little change due to heating, that is, excellent heat resistance, is desirably used, and besides an polyimide, an acrylic (methacrylic) or novolac resin material may be used. Photosensitivity is desirably added to these resin materials to facilitate patterning. Using the organic material having photosensitivity enables the bank to be formed by a series of processes of the application of the material, pre-bake, light exposure, development, and post-bake. The light for the exposure may be mixed light of g-, h-, and i-lines of ultraviolet (UV) light, or may also be a single wavelength of a g-, h-, or i-line. For the liquid developer, an organic or inorganic alkali aqueous solution may be used.

### <Light-emitting layer>

In the present invention, the light-emitting layer is preferably an organic light-emitting layer and generally contains an organic substance (a low molecular compound and a polymer compound) that mainly emits fluorescence or phosphorescence. The light-emitting layer may further contain a dopant material. Examples of a material that forms the light-emitting layer capable of being used in the present invention may include the following materials.

### Pigment material

Examples of pigment material may include a cyclopendamine derivative, a tetraphenyl butadiene derivative compound, a triphenyl amine derivative, an oxadiazole derivative, a pyrazoloquinoline derivative, a distyrylbenzene derivative, a distyrylarylene derivative, a pyrrole derivative, a thiophene ring compound, a pyridine ring compound, a perynone derivative, a perylene derivative, an oligothiophene derivative, a trifumanyl amine derivative, an oxadiazole dimmer and a pyrazoline dimmer.

### Metal complex material

Examples of a metal complex material may include: a metal complex such as a platinum complex and an iridium complex that emits light from the triplet excited state; and a metal complex that has Al, Zn and Be, or a rare-earth metal such as Tb, Eu and Dy, as a central metal, and has a structure of oxadiazole, thiadiazole, phenylpyridine, phenylbenzimidazole, quinoline, or the like, as a ligand, such as, an alumiquinolinol complex, a benzoquinolinole beryllium complex, a benzoxazolyl zinc complex, a benzothiazole zinc complex, an azomethyl zinc complex, a porphyrin zinc complex and an europium complex.

### Polymer material

Examples of a polymer material may include polyparaphenylene vinylene or a derivative thereof, polythiophene or a derivative thereof, polyparaphenylene or a derivative thereof, polysilane or a derivative thereof, polyacetylene or a derivative thereof, polyfluorene or a derivative thereof, polyvinyl carbazole or a derivative thereof and a material in which the pigment material or the metal complex material is polymerized.
Among the light-emitting materials, examples of the material that emits blue light may include: distyrylarylene or a derivative thereof, oxadiazole or a derivative thereof, and polymers of them; polyvinyl carbazole or a derivative thereof; polyparaphenylene or a derivative thereof; and polyfluorene or a derivative thereof. Among them, a polymer material such as polyvinyl carbazole or a derivative thereof; polyparaphenylene or a derivative thereof; and polyfluorene or a derivative thereof are preferred.
Examples of the material that emits green light may include: quinacridone or a derivative thereof, coumarin or a derivative thereof, and polymers of them; polyparaphenylene vinylene or a derivative thereof, and polyfluorene or a derivative thereof. Among them, a polymer material such as polyparaphenylene vinylene or a derivative thereof, and polyfluorene or a derivative thereof are preferred.
Examples of the material that emits red light may include: coumarin or a derivative thereof, a thiophene ring compound, and polymers of them; polyparaphenylene vinylene or a derivative thereof; polythiophene or a derivative thereof, and polyfluorene or a derivative thereof. Among them, a polymer material such as polyparaphenylene vinylene or a derivative thereof, polythiophene or a derivative thereof, and polyfluorene or a derivative thereof are preferred.

### Dopant material

A dopant may be added into the light-emitting layer for the purpose such as improving the light-emitting efficiency, or changing a light-emitting wavelength, and the like. Examples of such a dopant may include: perylene or a derivative thereof, coumarin or a derivative thereof, rubrene or a derivative thereof, quinacridone or a derivative thereof, squarylium or a derivative thereof, porphyrin or a derivative thereof, a styryl pigment, tetracene or a derivative thereof, pyrazolone or a derivative thereof, decacyclene and phenoxazon. The thickness of such a light-emitting layer is generally about 20 angstroms to 2000 angstroms (2 nanometers to 200 nanometers).

### <Film forming method of light-emitting layer>

For the film forming method of the light-emitting layer that contains an organic substance (organic light-emitting layer), a method of applying a solution containing a light-emitting material onto the substrate or to the upper side of the substrate, a vacuum deposition method, a transfer method, for example, may be used. Specific examples of a solvent used for forming a film from the solution may include a solvent similar to the solvent described above in which the hole transport material is dissolved when the hole transport layer is formed from the solution.
Examples of an available method of applying a solution containing a light-emitting material onto the substrate or to the upper side of the substrate may include applying methods such as: a coating method, for example, a spin coating method, a casting method, a micro-gravure coating method, a gravure coating method, a bar coating method, a roll coating method, a wire bar coating method, a dip coating method, a slit coating method, a capillary coating method, a spray coating method and a nozzle coating method; and a printing method, for example, a gravure printing method, a screen printing method, a flexo printing method, an offset printing method, a reverse printing method and an ink-jet printing method. The printing method such as a gravure printing method, a screen printing method, a flexo printing method, an offset printing method, a reverse printing method and an ink-jet printing method is preferable in that a pattern formation and color-coding in multiple colors are easily performed. For a sublimable low molecular compound, a vacuum deposition method may be used. Moreover, a method of forming a light-emitting layer only on a desired area by transfer using a laser or thermal transfer may also be used.

### <Electron transport layer>

As a material that constitutes the electron transport layer, a publicly known material may be used. Examples of the material may include an oxadiazole derivative, anthraquinodimethane or a derivative thereof, benzoquinone or a derivative thereof, naphthoquinone or a derivative thereof, anthraquinone or a derivative thereof, tetracyanoanthraquinodimethane or a derivative thereof, a fluorenone derivative, diphenyldicyanoethylene or a derivative thereof, a diphenoquinone derivative, a metal complex of 8-hydroxyquinoline or of a derivative of 8-hydroxyquinoline, polyquinoline or a derivative thereof, polyquinoxaline or a derivative thereof, and polyfluorene or a derivative thereof.

Among them, oxadiazole or a derivative thereof, benzoquinone or a derivative thereof, anthraquinone or a derivative thereof, a metal complex of 8-hydroxyquinoline or of a derivative of 8-hydroxyquinoline, polyquinoline or a derivative thereof, polyquinoxaline or a derivative thereof, and polyfluorene or a derivative thereof are preferred, and 2-(4-biphenyly)-5-(4-t-butylphenyl)-1,3,4-oxadiazole, benzoquinone, anthraquinone, tris(8-quinolinol)aluminum and polyquinoline are further preferred.

Although a film forming method of the electron transport layer is not particularly may limited, for a low molecular electron transport material, a vacuum deposition method from the powder, or a method of forming a film fro the solution or from the melted state is exemplified. For a polymer electron transport material, a method of forming a film from the solution or from the melted state is exemplified. When a film is formed from the solution or from the melted state, a polymer binder may also be used. Examples of a method of forming a film of the electron transport layer from the solution include a film forming method similar to the method of forming a film of the hole transport layer from the solution described above.

The optimal value for the film thickness of the electron transport layer varies depending on the material used. Although the film thickness may be selected to have appropriate values of driving voltage and light-emitting efficiency, at least a thickness with which no pinhole is formed is required. When the thickness is too large, the driving voltage of the element may increase. Accordingly, the film thickness of the electron transport layer is, for example, 1 nanometer to 1 micrometer, preferably, 2 nanometers to 500 nanometers, and more preferably, 5 nanometers to 200 nanometers.

### <Electron injection layer>

The electron injection layer is provided between the electron transport layer and the cathode or between the light-emitting layer and the cathode. Depending on the type of the light-emitting layer, examples of the electron injection layer may include: alkali metals and alkaline-earth metals; alloys that contain one or more types of the metals; oxides of the metals; halides of the metals; carbonates of the metals; or a mixture of these substances. Examples of the alkali metals, or the oxides, the halides and the carbonates of the alkali metals include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride and lithium carbonate. Examples of the alkaline-earth metals or the oxides, the halides, and the carbonates of the alkaline-earth metals may include magnesium, calcium, barium, strontium, magnesium oxide, magnesium fluoride, calcium oxide, calcium fluoride, barium oxide, barium fluoride, strontium oxide, strontium fluoride and magnesium carbonate. The electron injection layer may also be a laminated layer of two or more layers. Specific examples of the laminated layer may include LiF/Ca. The electron injection layer is formed by a vapor deposition method, a sputtering method, a printing method, or the like. The film thickness of the electron injection layer is preferably about 1 nanometer to 1 micrometer.

### <Cathode material>

For the material of the cathode used in the organic EL element of the present invention, a material that has a small work function, and facilitates electron injection into the light-emitting layer, a material having high electric conductivity, a material having the high reflectance of visible light, or a combination thereof is preferable. As metals, alkali metals, alkaline-earth metals, transition metals or the 13th-group metals may be used. Examples of the metals available may include: metals such as lithium, sodium, potassium, rubidium, cesium, beryllium, magnesium, calcium, strontium, barium, aluminum, scandium, vanadium, zinc, yttrium, indium, cerium, samarium, europium, terbium and ytterbium; alloys of two or more of the metals; alloys of one or more of the foregoing metals and one or more of gold, silver, platinum, copper, manganese, titanium, cobalt, nickel, tungsten and tin; or graphite or a graphite interlayer compound. Examples of the alloys may include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy. For the cathode, a transparent conductive electrode may be used; for example, a conductive metal oxide or a conductive organic substance may be used. Specifically, indium oxide, zinc oxide, tin oxide, and as complexes thereof, indium tin oxide (ITO) and indium zinc oxide (IZO) may be used as the conductive metal oxide, and an organic transparent conductive film of polyaniline or a derivative thereof, polythiophene or a derivative thereof, or the like may be used as the conductive organic substance. The cathode may be a stacked structure having two or more layers. The electron injection layer may be used as the cathode.

Although the film thickness of the cathode may be appropriately selected in consideration of electric conductivity and durability, the film thickness is, for example, 10 nanometers to 10 micrometers, preferably 20 nanometers to 1 micrometer, and more preferably 50 nanometers to 500 nanometers.

For a manufacturing method of the cathode, a vacuum deposition method, a sputtering method, a lamination method by which a metal thin film is press-bonded, for example, is used.

### <Insulating layer>

An insulating layer having a film thickness of equal to or less than 2 nanometers optionally included in the organic EL element of the present invention has a function facilitating charge injection. Examples of a material for the insulating layer may include metal fluorides, metal oxides, and organic insulating materials. Examples of the organic EL element that includes the insulating layer having a film thickness of equal to or less than 2 nanometers include: an organic EL element that includes the insulating layer having a film thickness of equal to or less than 2 nanometers at the position adjacent to the cathode; and an organic EL element that includes the insulating layer having a film thickness of equal to or less than 2 nanometers at the position adjacent to the anode.

The organic EL element of the present invention may be used for a planar light source, a segment display device, a dot-matrix display device, and the backlight of a liquid crystal display device.

### 9. Manufacturing method

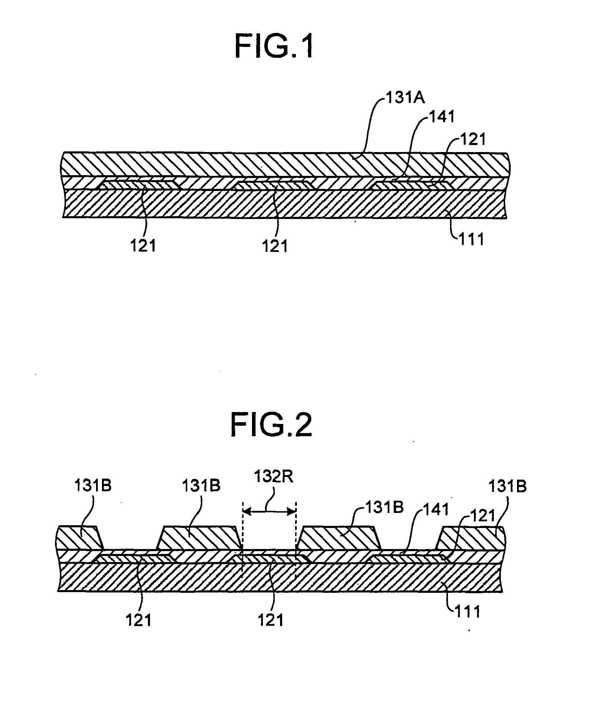

Examples of a preferable manufacturing method of the organic EL element of the present invention is described with reference to Figs. 1 to 3. Fig. 1 is a sectional schematic illustrating a manufacturing process in an example of a manufacturing method of the organic EL element of the present invention. Fig. 2 is a sectional schematic illustrating a manufacturing process subsequent to the manufacturing process illustrated in Fig. 1. Fig. 3 is a sectional schematic of a structure of a part of an example of the organic EL element of the present invention.
As illustrated in Fig. 1, the substrate 111 is prepared, and the first electrode layer 121 is provided on the surface of the substrate 111. The first electrode layer 121 may be provided in a desired pattern.
Then, the organic base layer 141 is provided to cover at least a part of, and preferably the whole of the first electrode layer 121. The organic base layer is composed of only one layer in the example illustrated in Fig. 1. However, when the organic base layer having two or more layers is provided, two or more layers may be stacked in this process. Although the organic base layer 141 may also be formed in a desired pattern, the organic base layer 141 may be easily provided by: providing the coating of the composition of the material for the organic base layer as a single seamless coating on the substrate 111 and on the first electrode layer 121 by a method such as spin coating; removing the layer at the position on which no organic base layer is formed (for example, the peripheral area 111S illustrated in Fig. 5) as needed; and further curing the coating as needed.

Subsequently, a photoresist layer 131A used for forming a bank is provided on the organic base layer 141.
As illustrated in Fig. 2, the part of the photoresist layer 131A at an area where the pixel area is formed, is removed by photolithography or the like, thus forming the bank 131B that defines the pixel area 132R.

As illustrated in Fig. 3, the organic light-emitting layer 142 is provided within the pixel area 132R defined by the bank 131B. The organic light-emitting layer 142 may be formed by providing the coating of the material composition for the organic light-emitting layer within the pixel area, and by curing the coating as needed. Examples of the method of providing the coating of the material composition within the pixel area may include preferably an ink-jet method. When a display element for single color display is constituted, the material composition of the organic light-emitting layer may be provided all over the element by a spin coating method or the like.

After the organic light-emitting layer 142 is provided, the second electrode layer 122 is provided thereon in a desired pattern to produce a laminated matter having substrate-first electrode layer-organic base layer-organic light-emitting layer-second electrode layer. In addition to this, optional components such as wiring necessary to drive sealing members and pixels may be further added as needed to produce an organic EL element.

### [Examples]

Although the present invention is described below in more detail with reference to Examples and Comparative Examples, the present invention is not limited thereto.

### Example 1

### (1-1: Formation of organic base layer)

A polymer material insoluble in water serving as a hole injection material, dipentaerythritol hexaacrylate serving as a cross-linking agent, and Irgacure 360 (manufactured by Nihon Ciba-Geigy K.K.) serving as a polymer initiator were mixed in a ratio by weight of 1:0.25:0.01, thus producing a mixture. One percent by mass of the mixture was dissolved in an organic solvent to produce ink for the organic base layer.
The ink for the organic base layer was applied on the whole surface of a flat glass substrate having an ITO pattern that served as an anode at the side having the pattern by spin coating, thus producing a coating having a thickness of about 60 nanometers. Subsequently, the coating at an area where a display element was not produced, such as a sealing area and the portion of a lead-out electrode, both of which were at the peripheral part of the substrate, was wiped off. The resultant coating was heat-treated on a hot plate at 200 degrees Celsius for 10 minutes, and dried to be insolubilized, thus producing an organic base layer functioning as a hole injection layer. The organic base layer was made of a crosslinked polymer compound insoluble in water. The resistivity of the organic base layer was equal to or more than 2×10¹⁴ Ωcm.

### (1-2: Formation of bank)

A photoresist (TELR-P003; manufactured by TOKYO OHKA KOGYO CO., LTD.) was applied on the organic base layer obtained at 1-1 by spin coating at a rotation speed of 1000 revolutions per minute, thus producing a photoresist layer. Exposure processing was performed on the layer using an exposure apparatus (MA-1200; manufactured by DAINIPPON SCREEN MFG. CO., LTD.) through a photomask in which a desired pattern was formed, and then the layer was developed with 1 percent by mass of a KOH aqueous solution, thus producing a desired pattern. The resultant film was dried in an oven at 230 degrees Celsius for 20 minutes to produce a bank. The resultant bank had a thickness of 1.5 micrometers. By observing the top surface of the bank from the above, openings for an element area where the organic base layer was exposed were found, and the opening had a rectangle of 70x210 micrometers, and had a distance from a neighboring element area of 20 micrometers.

### (1-3: Formation of light-emitting layer)

One percent by mass of a red color light-emitting organic EL material (Lumation RP158; manufactured by Sumation KK) in a xylene solution was applied by spin coating on the substrate, which was obtained at 1-2, having the anode, the organic base layer and the bank. Subsequently, unnecessary portions such as the peripheral portion of the substrate and the top portion of the bank were wiped off with a cloth soaked in xylene, and then the substrate was dried under reduced pressure at 80 degrees Celsius for 1 hour, thus producing a light-emitting layer having a thickness of 80 nanometers in the pixel area surrounded by the bank.

### (1-4: Formation of cathode)

An cathode made of two layers of barium having a thickness of about 5 nanometers and aluminum having a thickness of about 100 nanometers thereon was formed by a vapor deposition method on the substrate, which was obtained at (1-3), having the anode, the organic base layer, the bank and the light-emitting layer. The shape of the cathode was defined using a shadow mask to be a shape in which the cathode intersected with the ITO anode at right angles on the light-emitting layer to constitute a passive matrix with the anode and the cathode.

### (1-5: Sealing)

A UV curable sealing material (XNR5516Z; manufactured by Nagase ChemteX Corporation) was applied to the peripheral portion of one surface of a glass substrate for sealing by using a dispenser. The coated surface was positioned downward and was aligned with the substrate having a stacked structure obtained at (1-4) to be bonded under reduced pressure (-25 kilopascals). Subsequently, the pressure was returned to atmospheric pressure. The sealing member was irradiated with UV light to be cured, and thus the layer obtained at (1-1) to (1-4) was sealed to produce an organic EL element.

### (1-6: Evaluation)

Power was connected to the electrodes of the element obtained at (1-5) to drive the element, and then the display of a monochromatic (red color) image was confirmed. The light-emitting in the pixels was uniform.

### <Example 2>

A light-emitting layer polymer (Lumation G1302; manufactured by Sumation KK) was dissolved at 0.8 percent by mass in the organic solution same as that for the ink for the organic base layer, thus preparing ink having a viscosity of 8 centipoises.

The ink was applied onto a substrate including an anode, an organic base layer and a bank, that was obtained by the same manner with the steps (1-1) to (1-2) of Example 1, thus producing a light-emitting layer.
The application of the ink was performed by discharging 7 droplets of the ink to each of the pixel areas defined by the bank using an ink-jet apparatus 120L manufactured by Litrex Corporation.

After the ink application, the substrate was heat-treated in a vacuum at about 100 degrees Celsius for 60 minutes, and was processed in the same manner as the steps (1-4) to (1-5) of Example 1, thus producing an organic EL element.

Power was connected to the electrodes of the obtained element to drive the element, and then the display of a clear moving image with no crosstalk was confirmed. The leak current in one pixel was equal to or less than 0.1 microampere at -10 volts. The resistivity of the organic base layer was 2×10¹⁴ Ωcm.

### <Comparative Example 1>

### (1-1: Formation of organic base layer)

A substrate having an ITO anode and an organic base layer was produced in the same manner as the step (1-1) of Example 1, except that an aqueous solution containing water-soluble (poly(3,4-ethylenedioxythiophene)/polystyrene sulfonate (short title: PEDOT/PSS; trade name: Baytron P CH 8000; manufactured by Bayer AG) was used as ink for forming an organic base layer.
When the bank was to be formed on the resultant organic base layer in the same manner as the step (1-2) of Example 1, the thickness of the organic base layer became nonuniform at the process of photolithography for forming the bank.

### INDUSTRIAL APPLICABILITY

As described above, the organic EL element of the present invention is useful as, for example, the light sources of illumination devices and the display elements of display devices.

## Claims

1. An organic electroluminescence element comprising:
a substrate;
a first electrode layer that is provided above at least a partial area of a surface of the substrate;
an organic base layer that is provided above at least a partial area of a surface of the first electrode layer and is made of an organic material insoluble in water;
a bank that is provided above the organic base layer and is arranged with a plurality of pixel areas provided above the organic base layer;
an organic light-emitting layer provided above the organic base layer and within the pixel areas; and
a second electrode layer provided above the organic light-emitting layer.

2. The organic electroluminescence element according to claim 1, wherein the organic base layer is a hole injection layer.

3. The organic electroluminescence element according to claim 1, wherein the organic base layer includes a first organic base layer and a second organic base layer stacked above the first organic base layer, the first organic base layer is a hole injection layer, and the second organic base layer is an interlayer.

4. The organic electroluminescence element according to claim 1, wherein the resistivity of the organic base layer is equal to or more than 1×10¹⁰ Ωcm.

5. The organic electroluminescence element according to claim 1, wherein the organic material insoluble in water is a crosslinked polymer compound.

6. A method for manufacturing the organic electroluminescence element according to claim 1, the manufacturing method comprising:
preparing a substrate;
providing a first electrode layer above at least a partial area of a surface of the substrate;
providing an organic base layer above at least a partial area of the first electrode layer;
providing a bank above the organic base layer;
providing an organic light-emitting layer within a pixel area defined by the bank; and
providing a second electrode layer above the organic light-emitting layer.
